# EUROPÄISCHE PATENTSCHRIFT

(11) **EP 2 015 622 B1**
(45) Veröffentlichungstag und Bekanntmachung des Hinweises auf die Patenterteilung: **16.09.2009**
(21) Anmeldenummer: 07013738.5
(22) Anmeldetag: 12.07.2007
(51) Int. Cl.: H05K 3/30, H01H 13/26

(54) **Schalteinheit umfassend ein Trägerelement**
Switchgear unit comprising a mounting structure
Dispositif à interrupteur comprenant un support

(43) Veröffentlichungstag der Anmeldung: 14.01.2009
(73) Patentinhaber: Delphi Technologies, Inc., Troy, Michigan 48007 (US)
(72) Erfinder: Gärtner, Markus, 42117 Wuppertal (DE)
(74) Vertreter: Denton, Michael John

(56) Entgegenhaltungen:
- WO-A-00/77526
- DE-A1- 2 508 343
- DE-A1-102006 015 676
- GB-A- 2 423 412
- US-A1- 2003 209 789
- US-B1- 7 057 128

## Beschreibung

Die Erfindung betrifft eine Schalteinheit mit einem auf wenigstens einer Trägerfläche vorgesehenen elektrischen Kontakt-Layout und einer mit einem weiteren elektrisch leitenden Kontakt versehenen Betätigungselement, über das der dieser zugeordnete weitere Kontakt zur Erfüllung wenigstens einer elektrischen Schaltfunktion mit dem Kontakt-Layout in Eingriff bringbar ist. Sie betrifft ferner ein System mit einem Substrat und wenigstens einem auf dieses aufsteckbaren Schalteinheit.

Eine derartige Schalteinheit wird über das flexible Betätigungselement, das beispielsweise eine Elastomerschaltmatte, ein Schnappelement, eine Kontaktfeder und/oder dergleichen umfassen kann, nach Art eines Tastschalters betätigt, indem das Betätigungselement zur Auslösung der Schaltfunktion entsprechend eingedrückt wird. Das Kontakt-Layout ist üblicherweise mäanderförmig.

Für eine zuverlässige Schaltfunktion muss die Oberfläche des mäanderförmigen Kontakt-Layouts meistens vergoldet sein. Ist dieses Kontakt-Layout direkt auf einer gedruckten Schaltung oder Leiterplatte vorgesehen, so ist für diese Leiterplatte ein abschließendes Gold-Finish erforderlich. Bei der Leiterplattenherstellung trägt nun aber Gold zu einer spürbaren Kostensteigerung bei. Bewährte Ausführungen von Leiterplatten, wie beispielsweise in das Dachmodul eines Kraftfahrzeugs integrierte Leiterplatten besitzen außer der Schaltfunktionalität auch eine Vielzahl von SMD-Bauelementen (SMD = surface mounted device). Die Verbindungen zwischen der Leiterplatte und solchen SMD-Bauelementen benötigen keine vergoldeten Anschlussflächen. Hinzu kommt, dass eine Leiterplatte die Schalteinheiten auf eine zweidimensionale Ebene beschränkt. Schaltanwendungen stellen nun aber eine Benutzerschnittstelle dar, die von Hand betätigt werden müssen und entsprechend auch der Position beispielsweise des Fahrers oder eines Insassen eines Kraftfahrzeugs gerecht werden muss. Des bedeutet, dass die Schalteinheit eine besondere geometrische Form und zusätzliche Teile besitzen muss, die es gewährleisten, dass die bei einer Betätigung des Tastschalters aufgebrachten Kräfte auf das mäanderförmige Kontakt-Layout auf der Leiterplatte übertragen werden.

Der Erfindung liegt die Aufgabe zugrunde, eine verbesserte Schalteinheit sowie ein verbessertes System der eingangs genannten Art zu schaffen, bei denen die genannten Probleme beseitigt sind.

Diese Aufgabe wird erfindungsgemäß gelöst durch die Merkmale des Anspruchs 1.

Erfindungsgemäß wird somit eine Schalteinheit mit einem auf wenigstens einer Trägerfläche vorgesehenen elektrischen Kontakt-Layout und einer mit einem weiteren elektrisch leitenden Kontakt versehenen Betätigungselement angegeben, über das der dieser zugeordnete weitere Kontakt zur Erfüllung wenigstens einer elektrischen Schaltfunktion mit dem Kontakt-Layout in Eingriff bringbar ist, wobei die das Kontakt-Layout aufweisende Trägerfläche an einem Trägerelement vorgesehen ist, das mit einer Grundfläche auf ein Substrat aufsetzbar ist und zumindest zwei elektrische Anschlussflächen für eine elektrische Verbindung des Kontakt-Layouts mit dem Substrat zugeordneten elektrischen Anschlüssen umfasst.

Die Grundfläche des Trägerelements ist in seiner Form bevorzugt an die der Substratoberfläche angepasst.

Dabei kann die Grundfläche des Trägerelements insbesondere zumindest im Wesentlichen eben sein.

Von Vorteil ist insbesondere auch, wenn die das Kontakt-Layout aufweisende Trägerfläche des Trägerelements zumindest im Wesentlichen eben ist.

Die das Kontakt-Layout aufweisende Trägerfläche des Trägerelements kann einen beliebigen Winkel mit dessen Grundfläche einschließen, wobei dieser Winkel vorzugsweise in einem Bereich von 0° bis etwa 90° liegt.

Gemäß einer zweckmäßigen praktischen Ausgestaltung der erfindungsgemäßen Schalteinheit bildet die das Kontakt-Layout aufweisende Trägerfläche des Trägerelements mit dessen Grundfläche beispielsweise einen Winkel von etwa 45°.

Bei einer alternativen zweckmäßigen Ausführungsform liegt dieser Winkel im Bereich von 90°.

Bevorzugt besitzt das Trägerelement einen dreieckförmigen Querschnitt.

Gemäß einer weiteren vorteilhaften Ausführungsform der erfindungsgemäßen Schalteinheit kann die das Kontakt-Layout aufweisende Trägerfläche des Trägerelements zu dessen Grundfläche auch zumindest im Wesentlichen parallel sein. Das Trägerelement kann in diesem Fall also planar ausgeführt sein.

Bevorzugt besteht das Trägerelement aus Kunststoff. Es kann also insbesondere als Kunststoff-Spritzgussteil hergestellt werden.

Eine jeweilige Schalteinheit kann beispielsweise nach Art eines SMD-Elements auf das Substrat augesetzt sein oder beispielsweise zumindest einen von der Grundfläche abstehenden Ansatz zum Aufstecken des Trägerelements auf das mit wenigstens einem entsprechenden Loch versehene Substrat aufweisen. Im letzen Fall kann das Trägerelement insbesondere zumindest zwei sich von der Grundfläche weg erstreckende Ansätze umfassen. Von Vorteil ist insbesondere auch, wenn sich der bzw. die Ansätze zumindest im Wesentlichen senkrecht von der Grundfläche weg erstrecken.

Gemäß einer bevorzugten praktischen Ausführungsform der erfindungsgemäßen Schalteinheit ist das Trägerelement durch ein spritzgegossenes elektronisches MID-Bauteil (MID = molded interconnect device) gebildet.

Der bzw. die Ansätze können zumindest abschnittsweise zylindrisch ausgeführt sein.

Von Vorteil ist insbesondere auch, wenn der bzw. die Ansätze an ihren freien Enden konisch oder kegelstumpfartig ausgeführt sind. Damit lassen sich die Ansätze leichter in die betreffenden Öffnungen des Substrats einführen.

Bevorzugt sind der bzw. die Ansätze ausgehend von der Grundfläche des Trägerelements zunächst zumindest im Wesentlichen zylindrisch und an ihren Enden konisch oder kegelstumpfartig ausgeführt, wobei sich deren Querschnitt beim Übergang vom zylindrischen Abschnitt in den konisch bzw. kegelstumpfartigen Abschnitt vorzugsweise erweitert.

Der bzw. die Ansätze können an ihren freien Enden geschlitzt sein.

Wie bereits erwähnt, kann das Betätigungselement beispielsweise eine Elastomerschaltmatte, ein Schnappelement, eine Kontaktfeder und/oder dergleichen umfassen.

Das Kontakt-Layout kann insbesondere mäanderförmig ausgeführt sein.

Das Kontakt-Layout kann beispielsweise auch ein Stanzgitter oder dergleichen umfassen.

Bevorzugt ist das an einem jeweiligen Trägerelement vorgesehene Kontakt-Layout vergoldet.

Das erfindungsgemäße System zeichnet sich dadurch aus, dass es ein Substrat und wenigstens eine auf dieses aufsetzbare erfindungsgemäße Schalteinheit umfasst. Dabei können insbesondere auch unterschiedliche Ausführungen der erfindungsgemäßen Schalteinheit auf ein und demselben Substrat vorgesehen sein.

Die elektrischen Anschlussflächen eines jeweiligen Trägerelements sind mit den dem Substrat zugeordneten elektrischen Anschlüssen vorteilhafterweise verlötet.

Das Substrat kann beispielsweise eine gedruckte Schaltung oder Leiterplatte umfassen.

Gemäß einer vorteilhaften Ausführungsform des erfindungsgemäßen Systems umfasst das Substrat eine flexible gedruckte Schaltung.

Von Vorteil ist insbesondere auch, wenn das Substrat durch ein spritzgegossenes elektronisches MID-Bauteil (MID = molded interconnect device) gebildet ist.

Das Substrat kann zweckmäßigerweise ein HAL-Finish aufweisen.

An dem Trägerelement eines oder mehrerer Schalteinheiten kann beispielsweise auch jeweils wenigstens ein weiteres diskretes elektrisches Bauteil vorgesehen sein.

Ist das Trägerelement wenigstens einer Schalteinheit mit einem oder mehreren Ansätzen versehen, was, wie bereits erwähnt, nicht zwingend ist, so kann das Substrat mit einem oder mehreren Durchgangslöchern versehen sein, durch das bzw. die ein jeweiliger Ansatz eines Trägerelements hindurchsteckbar ist.

Die Erfindung ist also unter anderem auf Ausführungen von Schalteinheiten anwendbar, die auf einer Ausführung mit einer Elastomerschaltmatte oder dergleichen basieren. Die Elastomerschaltmatte bestimmt die Charakteristik beim Betätigen des Tastschalters und trägt einen elektrisch leitenden Kontakt, über den durch den Eingriff mit dem mäanderförmigen Kontakt-Layout ein oder mehrere Schaltkreise geschlossen werden.

Das Trägerelement der erfindungsgemäßen Schalteinheit kann beispielsweise durch ein MID-Bauteil verwirklicht werden, das das insbesondere mäanderförmige Kontakt-Layout trägt und an dem beispielsweise zwei Kontaktflächen vorgesehen sind, über die die betreffende Schalteinheit mit einem Substrat wie beispielsweise einer gedruckten Schaltung oder Leiterplatte, flexiblen gedruckten Schaltungen oder MID-Bauteil verlötet werden kann.

Das Trägerelement kann mit Ansätzen versehen sein, durch die eine einfache Montage sowie ein guter Sitz der Schalteinheit auf dem Substrat gewährleistet werden. Dies ist jedoch nicht zwingend.

Es sind z.B. unterschiedliche Ausführungen der Schalteinheit denkbar, bei denen die das Kontakt-Layout aufweisende Trägerfläche des Trägerelements mit dessen Grundfläche unterschiedliche Winkel bilden kann. Grundsätzlich sind beliebige Winkel denkbar. Bevorzugt kann diese das Kontakt-Layout aufweisende Trägerfläche beispielsweise einen Winkel von etwa 45° oder einen Winkel von beispielsweise 90° aufweisen. Denkbar ist beispielsweise auch eine Ausführung, bei der die das Kontakt-Layout aufweisende Trägerfläche des Trägerelements zu dessen Grundfläche zumindest im Wesentlichen parallel ist. Das Trägerelement kann in einem solchen Fall also insbesondere planar ausgeführt sein.

Der mechanische Sitz einer jeweiligen Schalteinheit auf dem Substrat ist gegebenenfalls durch den bzw. die Ansätze gewährleistet, die insbesondere so ausgeführt sein können, dass sie durch ein jeweiliges Durchgangsloch des Substrats hindurchgesteckt werden können. Eine jeweilige elektrische Verbindung ist bevorzugt durch eine jeweilige Lötstelle verwirklicht.

Die Schalteinheiten können insbesondere auch nach Art von SMD-Elementen insbesondere automatisch nach dem Baukastenprinzip auf das Substrat aufsetzbar sein.

Die Erfindung wird im Folgenden anhand von Ausführungsbeispielen unter Bezugnahme auf die Zeichnung näher erläutert. In dieser zeigen:
- Fig. 1: eine schematische perspektivische Teildarstellung einer beispielhaften Ausführungsform eines ein Substrat und wenigstens eine auf dieses aufsteckbare Schalteinheit umfassenden Systems,
- Fig. 2: eine schematische Längsschnittdarstellung des Systems, wobei der Schnitt durch mehrere Ansätze der Schalteinheiten geführt ist,
- Fig. 3: eine schematische perspektivische Darstellung einer beispielhaften Ausführungsform einer Schalteinheit, bei der eine das Kontakt-Layout aufweisende Trägerfläche des Trägerelements mit dessen Grundfläche einen Winkel von 45° bildet,
- Fig. 4: eine schematische Schnittdarstellung der Schalteinheit gemäß Fig. 3, wobei der Schnitt durch die Ansätze der Schalteinheit geführt ist,
- Fig. 5: eine schematische Ansicht der Schalteinheit gemäß Fig. 3 von unten,
- Fig. 6: eine schematische perspektivische Darstellung einer weiteren Ausführungsform der Schalteinheit, bei der eine das Kontakt-Layout aufweisende Trägerfläche des Trägerelements zu dessen Grundfläche parallel ist,
- Fig. 7: eine schematische Ansicht der Schalteinheit gemäß Fig. 6 von unten,
- Fig. 8: eine schematische Seitenansicht der Schalteinheit gemäß Fig. 6,
- Fig. 9: eine schematische perspektivische Darstellung einer weiteren Ausführungsform der Schalteinheit, bei der eine das Kontakt-Layout aufweisende Trägerfläche des Trägerelements mit dessen Grundfläche einen Winkel von 90° bildet,
- Fig. 10: eine schematische Ansicht der Schalteinheit gemäß Fig. 9 von unten und
- Fig. 11: eine schematische Schnittdarstellung der Schalteinheit gemäß Fig. 10 wobei der Schnitt durch die Ansätze der Schalteinheit geführt ist.

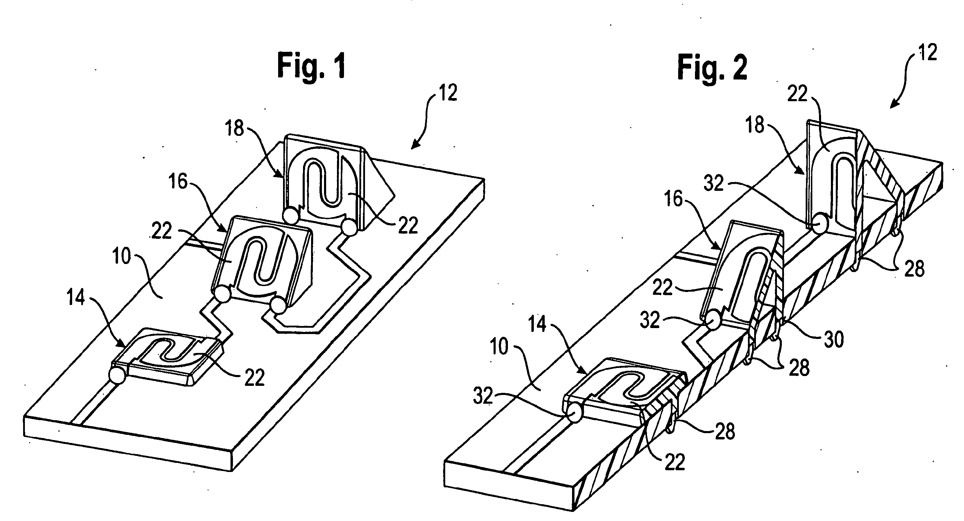

Fig. 1 zeigt in schematischer perspektivischer Teildarstellung eine beispielhafte Ausführungsform eines ein Substrat 10 und wenigstens eine auf dieses aufsteckbare Schalteinheit umfassenden Systems 12, wobei im vorliegenden Fall drei solche Schalteinheiten 14, 16, 18 zu erkennen sind, die hier beispielsweise einen unterschiedlichen Aufbau besitzen.

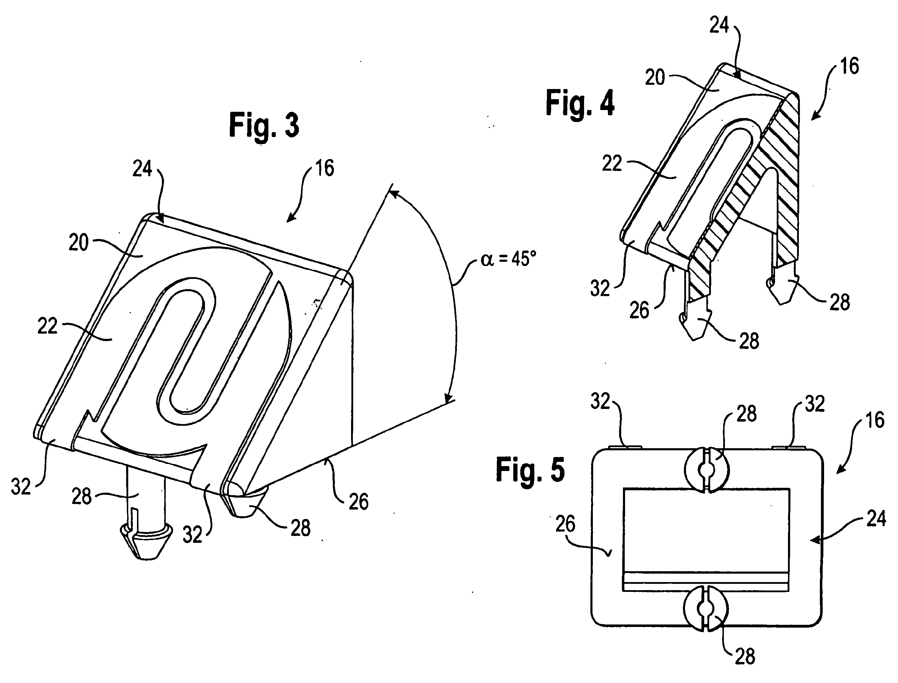

Die Schalteinheiten 14 - 18 umfassen jeweils ein auf einer Trägerfläche 20 (vgl. auch die Fig. 3, 4, 6, 8, 9 und 11) vorgesehenes elektrisches Kontakt-Layout 22 und ein mit einem weiteren elektrischen Kontakt versehenes Betätigungselement (nicht gezeigt), über das der dieser zugeordnete weitere Kontakt zur Erfüllung wenigstens einer elektrischen Schaltfunktion mit dem Kontakt-Layout 22 in Eingriff bringbar ist. Das Betätigungselement kann beispielsweise eine Elastomerschaltmatte, ein Schnappelement, eine Kontaktfeder und/oder dergleichen umfassen.

Das Kontakt-Layout 22 kann grundsätzlich auch auf verschiedenen Trägerflächen des Trägerelements 24, d. h. beispielsweise auch umgreifend vorgesehen sein. So können beispielsweise die Anschlussflächen 32 auf der Unterseite bzw. Grundfläche 36 weitergeführt sein.

Wie insbesondere auch anhand der Fig. 3 bis 11 zu erkennen ist, ist die das Kontakt-Layout 22 aufweisende Trägerfläche 20 an einem Trägerelement 24 vorgesehen, das zudem eine Grundfläche 26 besitzt, mit der es auf das Substrat 10 aufsetzbar ist.

Das Trägerelement 24 einer jeweiligen Schalteinheit 14 - 18 umfasst beispielsweise zwei elektrische Anschlussflächen 32 für eine elektrische Verbindung des Kontakt-Layouts 22 mit dem Substrat 10 zugeordneten elektrischen Anschlüssen.

Zudem umfassen die Schaltelemente 14 - 18 jeweils wenigstens einen, im vorliegenden Fall beispielsweise jeweils wenigstens zwei sich von der Grundfläche 26 des Trägerelements 24 weg erstreckende Ansätze 28 zum Aufstecken des Trägerelements 24 auf das mit entsprechenden Löchern, insbesondere Durchgangslöchern 30 (vgl. Fig. 2) versehene Substrat 10. Diese Ansätze 28 sind jedoch nicht zwingend.

Wie insbesondere anhand der Fig. 3, 4, 6, 8, 9 und 11 zu erkennen ist, können sich die Ansätze 28 zumindest im Wesentlichen senkrecht von der Grundfläche 26 weg erstrecken.

Die Grundfläche 26 des Trägerelements 24 eines jeweiligen Schaltelements 14 - 18 kann in seiner Form an die der Substratoberfläche angepasst sein. Bei den vorliegenden Ausführungsformen ist die Grundfläche 26 des Trägerelements 24 zumindest im Wesentlichen eben.

Auch die das Kontakt-Layout 22 aufweisende Trägerfläche des Trägerelements 24 eines jeweiligen Schaltelements 14 - 18 ist im vorliegenden Fall beispielsweise zumindest im Wesentlichen eben.

Fig. 2 zeigt eine schematische Längsschnittdarstellung des Systems 12, wobei der Schnitt durch mehrere Ansätze 28 der Schalteinheiten 14 - 18 geführt ist.

Fig. 3 zeigt in schematischer perspektivischer Darstellung eine beispielhafte Ausführungsform einer Schalteinheit 16, bei der die das Kontakt-Layouts 22 aufweisende Trägerfläche 20 des Trägerelements 24 mit dessen Grundfläche 26 einem Winkel α von 45° bildet.

Wie anhand der Fig. 3 zu erkennen ist, können die Anschlussflächen 32 beispielsweise im Bereich des unteren Randes der Trägerfläche 20 vorgesehen sein. Wie bereits erwähnt, können sie beispielsweise auch auf die Unterseite bzw. Grundfläche 20 weitergeführt sein.

Das Trägerelement 24 ist im vorliegenden Fall mit beispielsweise zwei sich senkrecht von der Grundfläche 26 weg erstreckenden kreiszylindrischen Ansätzen 28 versehen, die am freien Ende jeweils kegelstumpfartig ausgeführt sind, wobei sich beim Übergang vom zylindrischen Abschnitt in den kegelstumpfartigen Endabschnitt deren Querschnitt erweitert.

In Fig. 4 ist die Schalteinheit 16 gemäß Fig. 3 in einer schematischen Schnittdarstellung angegeben, wobei der Schnitt durch die Ansätze 28 geführt ist.

Fig. 5 zeigt die Schalteinheit 16 gemäß Fig. 3 in einer schematischen Ansicht von unten.

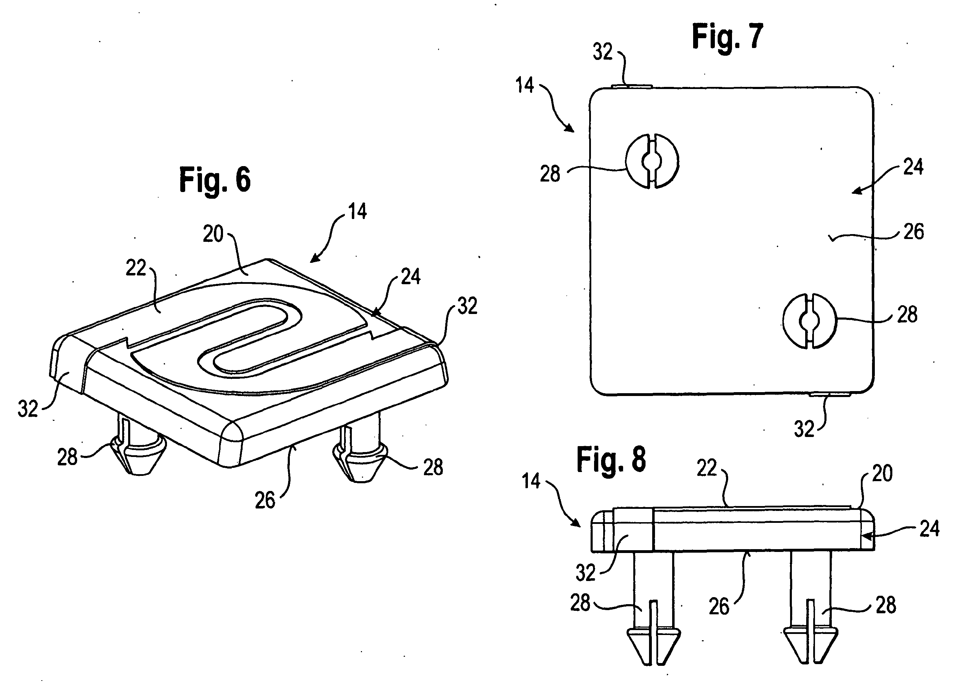

Fig. 6 zeigt in schematischer perspektivischer Darstellung eine weitere Ausführungsform einer Schalteinheit 14, bei der die das Kontakt-Layout 22 aufweisende Trägerfläche 20 des Trägerelements 24 zu dessen Grundfläche 26 parallel ist. Das Trägerelement 24 kann in diesem Fall also, wie dargestellt, planar ausgeführt sein.

Die Anschlussflächen 32 sind hier an einander gegenüberliegenden Rändern des Trägerelements 24 vorgesehen.

Es sind auch in diesem Fall wieder zwei sich senkrecht von der Grundfläche 26 weg erstreckende Ansätze 28 vorgesehen. Diese können beispielsweise wieder so ausgeführt sein, wie die der Ausführung gemäß den Fig. 3 bis 5. Während die beiden Ansätze 28 bei der Ausführungsform gemäß den Fig. 3 bis 5 auf einander gegenüberliegenden Seiten der Grundfläche 26 mittig angeordnet sind, sind die beiden Ansätze 28 beim vorliegenden Ausführungsbeispiel gemäß der Fig. 6 auf einer Diagonalen der Grundfläche 26 angeordnet (vgl. insbesondere auch Fig. 7).

Fig. 7 zeigt die Schalteinheit 14 gemäß Fig. 6 in einer schematischen Ansicht von unten. Fig. 8 zeigt eine schematische Seitenansicht der Schalteinheit 14 gemäß Fig. 6.

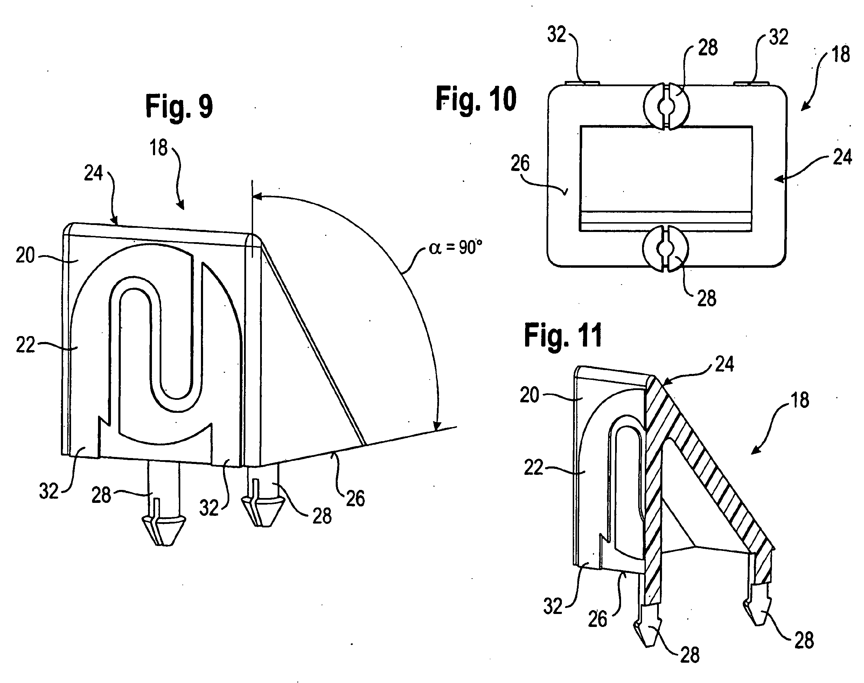

Fig. 9 zeigt in schematischer perspektivischer Darstellung eine weitere Ausführungsform einer Schalteinheit 18, bei der die das Kontakt-Layout 22 aufweisende Trägerfläche 20 des Trägerelements 24 mit dessen Grundfläche 26 einen Winkel α von 90° bildet.

Wie anhand der Fig. 9 zu erkennen ist, können die elektrischen Anschlussflächen 32 im vorliegenden Fall wieder im Bereich des unteren Randes der Trägerfläche 20 vorgesehen sein.

Die beiden Ansätze 28 können beispielsweise wieder so ausgeführt sein, wie die der Schalteinheit 16 gemäß Fig. 3. Wie insbesondere anhand der Fig. 10 zu erkennen ist, können die beiden Ansätze 28 auch im vorliegenden Fall beispielsweise wieder aufeinander gegenüberliegenden Seiten der Grundfläche 26 mittig angeordnet sein.

Fig. 10 zeigt die Schalteinheit 18 gemäß Fig. 9 in einer schematischen Ansicht von unten.

In Fig. 11 ist die Schalteinheit 18 gemäß Fig. 9 in einer schematischen Schnittdarstellung wiedergegeben, wobei der Schnitt durch die Ansätze 28 der Schalteinheit 18 geführt ist.

Wie insbesondere anhand der Fig. 3 und 9 zu erkennen ist, kann das Trägerelement 24 insbesondere in den Fällen, in denen die Trägerfläche 20 mit der Grundfläche 26 einen Winkel zwischen 0° und 90° bildet, beispielsweise einen dreieckförmigen Querschnitt besitzen.

Das Trägerelement 24 einer jeweiligen Schalteinheit 14 - 18 kann insbesondere aus Kunststoff bestehen. Es kann also insbesondere durch ein Spritzgussteil gebildet sein.

Grundsätzlich kann ein solches Trägerelement 24 auch durch ein spritzgegossenes elektronisches MID-Bauteil gebildet sein.

Wie insbesondere den Fig. 3, 5 und 6 bis 10 entnommen werden kann, können die Ansätze 28 zumindest an ihren freien Enden geschlitzt sein.

Bei den vorliegenden Ausführungsbeispielen ist das Kontakt-Layout 22 jeweils beispielsweise mäanderförmig ausgeführt.

Das an einem jeweiligen Trägerelement 24 vorgesehene Kontakt-Layout 22 kann insbesondere vergoldet sein.

Die elektrischen Anschlussflächen 32 eines jeweiligen Trägerelements können mit den dem Substrat 10 zugeordneten elektrischen Anschlüssen insbesondere verlötet sein.

Bei dem Substrat 10 kann es sich beispielsweise um eine gedruckte Schaltung oder Leiterplatte, eine flexible gedruckte Schaltung oder beispielsweise auch um ein spritzgegossenes elektronisches MID-Bauteil handeln.

Das Substrat 10 kann beispielsweise ein HAL-Finish aufweisen.

Wie anhand der Fig. 1 und 2 zu erkennen ist, können auf einem jeweiligen Substrat insbesondere auch unterschiedliche Schaltelemente 14 - 18 aufgebracht sein. So sind in der Fig. 1 beispielsweise drei unterschiedliche Schalteinheiten 14 - 18 der Art zu erkennen, wie sie in den Fig. 3 bis 11 näher beschrieben sind.

### Bezugszeichenliste

- 10: Substrat
- 12: System
- 14: Schalteinheit
- 16: Schalteinheit
- 18: Schalteinheit
- 20: Trägerfläche
- 22: Kontakt-Layout
- 24: Trägerelement
- 26: Grundfläche
- 28: Ansatz
- 30: Loch, Durchgangsloch
- 32: Anschlussfläche
- α: Winkel zwischen Trägerfläche und Grundfläche

## Patentansprüche

1. Schalteinheit (14, 16, 18) mit einem auf wenigstens einer Trägerfläche (20) vorgesehenen elektrischen Kontakt-Layout (22) und einer mit einem weiteren elektrisch leitenden Kontakt versehenen Betätigungselement, über das der dieser zugeordnete weitere Kontakt zur Erfüllung wenigstens einer elektrischen Schaltfunktion mit dem Kontakt-Layout (22) in Eingriff bringbar ist,
**dadurch gekennzeichnet,**
**dass** die das Kontakt-Layout (22) aufweisende Trägerfläche (20) an einem Trägerelement (24) vorgesehen ist, das mit einer Grundfläche (26) auf ein Substrat (10) aufsetzbar ist und zumindest zwei elektrische Anschlussflächen (32) für eine elektrische Verbindung des Kontakt-Layouts (22) mit dem Substrat (10) zugeordneten elektrischen Anschlüssen umfasst.

2. Schalteinheit nach Anspruch 1,
**dadurch gekennzeichnet,**
**dass** die Grundfläche (26) des Trägerelements (24) in seiner Form an die der Substratoberfläche angepasst ist.

3. Schalteinheit nach Anspruch 1 oder 2,
**dadurch gekennzeichnet,**
**dass** die Grundfläche (26) des Trägerelements (24) eben ist.

4. Schalteinheit nach einem der vorhergehenden Ansprüche,
**dadurch gekennzeichnet,**
**dass** die das Kontakt-Layout (22) aufweisende Trägerfläche (20) des Trägerelements (24) eben ist.

5. Schalteinheit nach einem der vorhergehenden Ansprüche,
**dadurch gekennzeichnet,**
**dass** die das Kontakt-Layout (22) aufweisende Trägerfläche (20) des Trägerelements (24) mit dessen Grundfläche (26) einen Winkel (α) in einem Bereich von 0° bis 90° bildet.

6. Schalteinheit nach Anspruch 5,
**dadurch gekennzeichnet,**
**dass** die das Kontakt-Layout (22) aufweisende Trägerfläche (20) des Trägerelements (24) mit dessen Grundfläche (26) einen Winkel (α) von 45° bildet.

7. Schalteinheit nach Anspruch 6,
**dadurch gekennzeichnet,**
**dass** die das Kontakt-Layout (22) aufweisende Trägerfläche (20) des Trägerelements (24) mit dessen Grundfläche (26) einen Winkel (α) von 90° bildet.

8. Schalteinheit nach einem der Ansprüche 5 bis 7,
**dadurch gekennzeichnet ,**
**dass** das Trägerelement (24) einen dreieckförmigen Querschnitt besitzt.

9. Schalteinheit nach Anspruch 5,
**dadurch gekennzeichnet,**
**dass** die das Kontakt-Layout (22) aufweisende Trägerfläche (20) des Trägerelements (24) zu dessen Grundfläche (26) zumindest im Wesentlichen parallel ist.

10. Schalteinheit nach Anspruch 9,
**dadurch gekennzeichnet,**
**dass** das Trägerelement (24) planar ausgeführt ist.

11. Schalteinheit nach einem der vorhergehenden Ansprüche,
**dadurch gekennzeichnet,**
**dass** das Trägerelement (24) als Hohlkörper ausgeführt ist.

12. Schalteinheit nach einem der vorhergehenden Ansprüche,
**dadurch gekennzeichnet,**
**dass** das Trägerelement (24) aus Kunststoff besteht.

13. Schalteinheit nach einem der vorhergehenden Ansprüche,
**dadurch gekennzeichnet,**
**dass** das Trägerelement (24) zumindest einen von der Grundfläche (26) abstehenden Ansatz (28) zum Aufstecken des Trägerelements (24) auf das mit wenigstens einem entsprechend Loch (30) versehene Substrat (10) aufweist.

14. Schalteinheit nach Anspruch 13,
**dadurch gekennzeichnet,**
**dass** das Trägerelement (24) zumindest zwei sich von der Grundfläche (26) weg erstreckende Ansätze (28) umfasst.

15. Schalteinheit nach Anspruch 13 oder 14,
**dadurch gekennzeichnet,**
**dass** sich der bzw. die Ansätze (28) senkrecht von der Grundfläche (26) wegerstrecken.

16. Schalteinheit nach einem der vorhergehenden Ansprüche,
**dadurch gekennzeichnet,**
**dass** das Trägerelement (24) durch ein spritzgegossenes elektronisches MID-Bauteil (MID = moulded interconnect device) gebildet ist.

17. Schalteinheit nach einem der vorhergehenden Ansprüche,
**dadurch gekennzeichnet,**
**dass** der bzw. die Ansätze (28) zumindest abschnittsweise zylindrisch ausgeführt sind.

18. Schalteinheit nach einem der vorhergehenden Ansprüche,
**dadurch gekennzeichnet,**
**dass** der bzw. die Ansätze (28) an Ihren freien Enden konisch oder kegelstumpfartig ausgeführt sind.

19. Schalteinheit nach Anspruch 17 oder 18,
**dadurch gekennzeichnet,**
**dass** der bzw. die Ansätze (28) ausgehend von der Grundfläche (26) des Trägerelements (24) zunächst zumindest im Wesentlichen zylindrisch und an Ihren Enden konisch oder kegelstumpfartig ausgeführt sind und dass sich deren Querschnitt beim Übergang vom zylindrischen Abschnitt in den konisch bzw. kegelstumpfartigen Endabschnitt vorzugsweise erweitert.

20. Schalteinheit nach einem der vorhergehenden Ansprüche,
**dadurch gekennzeichnet,**
**dass** der bzw. die Ansätze (28) zumindest an ihren freien Enden geschlitzt sind.

21. Schalteinheit nach einem der vorhergehenden Ansprüche,
**dadurch gekennzeichnet ,**
**dass** das Betätigungselement eine Elastomerschaltmatte, ein Schnappelement, eine Kontaktfeder umfasst.

22. Schalteinheit nach einem der vorhergehenden Ansprüche,
**dadurch gekennzeichnet ,**
**dass** das Kontakt-Layout (22) mäanderförmig ausgeführt ist.

23. Schalteinheit nach einem der vorhergehenden Ansprüche,
**dadurch gekennzeichnet ,**
**dass** das Kontakt-Layout (22) ein Stanzgitter umfasst.

24. Schalteinheit nach einem der vorhergehenden Ansprüche,
**dadurch gekennzeichnet ,**
**dass** das an einem jeweiligen Trägerelement (24) vorgesehene Kontakt-Layout (22) vergoldet ist.

25. System (12) mit einem Substrat (10) und wenigstens einer auf dieses aufsetzbaren Schalteinheit (14-18) nach einem der vorhergehenden Ansprüche.

26. System nach Anspruch 25,
**dadurch gekennzeichnet ,**
**dass** die elektrischen Anschlussflächen (32) eines jeweiligen Trägerelements (24) mit den dem Substrat zugeordneten elektrischen Anschlüssen verlötet sind.

27. System nach einem der vorhergehenden Ansprüche,
**dadurch gekennzeichnet,**
**dass** das Substrat (10) eine gedruckte Schaltung oder Leiterplatte umfasst.

28. System nach einem der vorhergehenden Ansprüche,
**dadurch gekennzeichnet,**
**dass** das Substrat (10) eine flexible gedruckte Schaltung umfasst.

29. System nach einem der vorhergehenden Ansprüche,
**dadurch gekennzeichnet,**
**dass** das Substrat (10) durch ein spritzgegossenes elektronisches MID-Bauteil (MID = moulded interconnect device) gebildet ist.

30. System nach einem der vorhergehenden Ansprüche,
**dadurch gekenntzeichnet,**
dass das Substrat (10) ein HAL-Finish aufweist.

31. System nach einem der vorhergehenden Ansprüche,
**dadurch gekennzeichnet,**
**dass** an dem Trägerelement (24) wenigstens einer Schalteinheit wenigstens ein weiteres diskretes elektrisches Bauteil vorgesehen ist.

32. System nach einem der vorhergehenden Ansprüche,
**dadurch gekennzeichnet,**
**dass** das Substrat (10) mit wenigstens einem Durchgangsloch (30) versehen ist, durch das ein jeweiliger Ansatz (28) eines Trägerelements (24) hindurchsteckbar ist.

## Claims

1. Switching unit (14, 16, 18) including an electrical contact layout (22) provided on at least a support surface (20) and an actuating member provided with another electrical conductive contact, through which the associated further contact is engageable with the contact layout (22) for providing at least an electrical switching function,
**characterized in that**
the support surface (20) comprising the contact layout (22) is provided at a support member (24) which is attachable with a base (26) on a substrate (10) and includes at least two electrical pads (32) for an electrical connection of the contact layout (22) with electrical terminals associated with the substrate (10).

2. Switching unit according to claim 1,
**characterized in that**
the base (26) of the support member (24) is adapted in its form to that of the substrate surface.

3. Switching unit according to claim 1 or 2,
**characterized in that**
the base (26) of the support member (24) is planar.

4. Switching unit according to one of the preceding claims,
**characterized in that**
the support surface (20) of the support member (24) comprising the contact layout (22) is planar.

5. Switching unit according to one of the preceding claims,
**characterized in that**
the support surface (20) of the support member (24) comprising the contact layout (22) forms with its base (26) an angle (α) in a range of 0° to 90°.

6. Switching unit according to claim 5,
**characterized in that**
the support surface (20) of the support member (24) comprising the contact layout (22) forms with its base (26) an angle (α) of 45°.

7. Switching unit according to claim 6,
**characterized in that**
the support surface (20) of the support member (24) comprising the contact layout (22) forms with its base (26) an angle (α) of 90°.

8. Switching unit according to one of the claims 5 to 7,
**characterized in that**
the support member (24) has a triangular cross section.

9. Switching unit according to claim 5,
**characterized in that**
the support surface (20) of the support member (24) comprising the contact layout (22) is at least essentially parallel to its base (26).

10. Switching unit according to claim 9,
**characterized in that**
the support member (24) is arranged planar.

11. Switching unit according to one of the preceding claims,
**characterized in that**
the support member (24) is arranged as a hollow body.

12. Switching unit according to one of the preceding claims,
**characterized in that**
the support member (24) consists of plastic.

13. Switching unit according to one of the preceding claims,
**characterized in that**
the support member (24) comprises at least one projection (28) projecting from the base (26) for attaching the support member (24) onto the substrate (10) provided with at least one corresponding hole (30).

14. Switching unit according to claim 13,
**characterized in that**
the support member (24) comprises at least two projections (28) extending away from the base (26).

15. Switching unit according to claim 13 or 14,
**characterized in that**
the projection(s) (28) extend away perpendicular to the base (26).

16. Switching unit according to one of the preceding claims,
**characterized in that**
the support member (24) is formed of an injection moulded electronic MID component (MID = moulded interconnect device).

17. Switching unit according to one of the preceding claims,
**characterized in that**
the projection(s) (28) is/are formed cylindrical at least in sections.

18. Switching unit according to one of the preceding claims,
**characterized in that**
the projection(s) (28) is/are formed conical or truncated at their free ends.

19. Switching unit according to claim 17 or 18,
**characterized in that**
the projection(s) (28), beginning from the base (26) of the support member (24), initially is/are at least essentially cylindrical and at their ends conical or truncated and that their cross section preferably enlarges at the change from the cylindrical section to the conical or truncated end section.

20. Switching unit according to one of the preceding claims,
**characterized in that**
the projection(s) (28) are slotted at least at their free ends.

21. Switching unit according to one of the preceding claims,
**characterized in that**
the actuating member includes an elastomeric switching mat, a snapping element, a contact spring.

22. Switching unit according to one of the preceding claims,
**characterized in that**
the contact layout (22) is formed meander-like.

23. Switching unit according to one of the preceding claims,
**characterized in that**
the contact layout (22) includes a punching grid.

24. Switching unit according to one of the preceding claims,
**characterized in that**
the contact layout (22), provided at a respective support member (24), is gilded.

25. System (12) with a substrate (10) and at least one switching unit (14-18) attachable thereon according to one of the preceding claims.

26. System according to claim 25,
**characterized in that**
the electrical pads (32) of a respective support member (24) are soldered with the electrical terminals associated with the substrate.

27. System according to one of the preceding claims,
**characterized in that**
the substrate (10) includes a printed circuit or circuit board.

28. System according to one of the preceding claims,
**characterized in that**
the substrate (10) includes a flexible printed circuit.

29. System according to one of the preceding claims,
**characterized in that**
the substrate (10) is formed of an injection moulded electronic MID component (MID = moulded interconnect device).

30. System according to one of the preceding claims,
**characterized in that**
the substrate (10) comprises a HAL finish.

31. System according to one of the preceding claims,
**characterized in that**
at least one other discrete electrical component is provided at the support member (24) of at least one switching unit.

32. System according to one of the preceding claims,
**characterized in that**
the substrate (10) is provided with at least one through hole (30), through which a respective projection (28) of a support member (24) is insertable.

## Revendications

1. Unité de commutation (14, 16, 18) comprenant une configuration de contact électrique (22) prévue sur au moins une surface portante (20), et un élément d'actionnement pourvu d'un autre contact électroconducteur, élément d'actionnement au moyen duquel l'autre contact qui lui est associé est susceptible d'être amené en engagement avec la configuration de contact (22) pour remplir au moins une fonction de commutation électrique,
**caractérisée en ce que** la surface portante (20) qui comporte la configuration de contact (22) est prévue sur un élément porteur (24), celui-ci pouvant être posé sur un substrat (10) avec une surface de base (26) et comprenant au moins deux surfaces de raccordement électrique (32) pour une liaison électrique de la configuration de contact (22) avec les raccords électriques associés au substrat (10).

2. Unité de commutation selon la revendication 1,
**caractérisée en ce que** la surface de base (26) de l'élément porteur (24) est adaptée quant à sa forme à celle de la surface du substrat.

3. Unité de commutation selon la revendication 1 ou 2,
**caractérisée en ce que** la surface de base (26) de l'élément porteur (24) est plane.

4. Unité de commutation selon l'une des revendications précédentes,
**caractérisée en ce que** la surface portante (20) de l'élément porteur (24), qui présente la configuration de contact (22), est plane.

5. Unité de commutation selon l'une des revendications précédentes,
**caractérisée en ce que** la surface portante (20) de l'élément porteur (24), qui présente la configuration de contact (22), définit avec sa surface de base (26) un angle (α) dans une plage de 0° à 90°.

6. Unité de commutation selon la revendication 5,
**caractérisée en ce que** la surface portante (20) de l'élément porteur (24), qui présente la configuration de contact (22), définit avec sa surface de base (26) un angle (α) de 45°.

7. Unité de commutation selon la revendication 6,
**caractérisée en ce que** la surface portante (20) de l'élément porteur (24), qui présente la configuration de contact (22), définit avec sa surface de base (26) un angle (α) de 90°.

8. Unité de commutation selon l'une des revendications 5 à 7,
**caractérisée en ce que** l'élément porteur (24) possède une section de forme triangulaire.

9. Unité de commutation selon la revendication 5,
**caractérisée en ce que** la surface portante (20) de l'élément porteur (24), qui présente la configuration de contact (22) est au moins sensiblement parallèle à sa surface de base (26).

10. Unité de commutation selon la revendication 9,
**caractérisée en ce que** l'élément porteur (24) est réalisé plan.

11. Unité de commutation selon l'une des revendications précédentes,
**caractérisée en ce que** l'élément porteur (24) est réalisé sous forme de corps creux.

12. Unité de commutation selon l'une des revendications précédentes,
**caractérisée en ce que** l'élément porteur (24) est en matière plastique.

13. Unité de commutation selon l'une des revendications précédentes,
**caractérisée en ce que** l'élément porteur (24) comporte au moins un talon (24) qui dépasse de la surface de base (26), pour enficher l'élément porteur (24) sur le substrat (10) pourvu d'au moins un trou correspondant (30).

14. Unité de commutation selon la revendication 13,
**caractérisée en ce que** l'élément porteur (24) comprend au moins deux talons (28) qui s'étendent en éloignement de la surface de base (26).

15. Unité de commutation selon la revendication 13 ou 14,
**caractérisée en ce que** le ou les talon(s) (28) s'étend(ent) perpendiculairement de la surface de base (26).

16. Unité de commutation selon l'une des revendications précédentes,
**caractérisée en ce que** l'élément porteur (24) est formé par un composant électronique enrobé par injection dit "MID" (moulded interconnect device).

17. Unité de commutation selon l'une des revendications précédentes,
**caractérisée en ce que** le ou les talon(s) (28) est/sont réalisé(s) de manière cylindrique au moins par tronçons.

18. Unité de commutation selon l'une des revendications précédentes,
**caractérisée en ce que** le ou les talon(s) (28) est/sont réalisé(s) sous forme conique ou tronconique à son/leurs extrémité(s) libre(s).

19. Unité de commutation selon la revendication 17 ou 18,
**caractérisée en ce que** le ou les talon(s) (28) est/sont réalisé(s), en partant de la surface de base (26) de l'élément porteur (24), tout d'abord au moins sensiblement cylindrique, et sous forme conique ou tronconique à son/leurs extrémité(s), et **en ce que** sa/leur section transversale s'élargit de préférence à la transition depuis le tronçon cylindrique vers le tronçon terminal de forme conique ou tronconique.

20. Unité de commutation selon l'une des revendications précédentes,
**caractérisée en ce que** le ou les talon(s) (28) est/sont fendu(s) au moins à son/leurs extrémité(s) libre(s).

21. Unité de commutation selon l'une des revendications précédentes,
**caractérisée en ce que** l'élément d'actionnement comprend un tapis de commutation en élastomère, un élément à encliquetage, ou une lame-ressort de contact.

22. Unité de commutation selon l'une des revendications précédentes,
**caractérisée en ce que** la configuration de contact (22) est réalisée en forme de méandres.

23. Unité de commutation selon l'une des revendications précédentes,
**caractérisée en ce que** la configuration de contact (22) comprend une grille poinçonnée.

24. Unité de commutation selon l'une des revendications précédentes,
**caractérisée en ce que** la configuration de contact (22) prévue sur un élément porteur respectif (24) est dorée.

25. Système (12) comprenant un substrat (10) et au moins une unité de commutation (14-18) selon l'une des revendications précédentes, susceptible d'être posée sur ce substrat.

26. Système selon la revendication 25,
**caractérisé en ce que** les surfaces de raccordement électriques (32) d'un élément porteur respectif (24) sont brasées avec les raccordements électriques associés au substrat.

27. Système selon l'une des revendications précédentes,
**caractérisé en ce que** le substrat (10) comprend un circuit imprimé ou une carte à circuits.

28. Système selon l'une des revendications précédentes,
**caractérisé en ce que** le substrat (10) comprend un circuit imprimé flexible.

29. Système selon l'une des revendications précédentes,
**caractérisé en ce que** le substrat est formé par un composant électronique enrobé par injection dit "MID" (moulded interconnect device).

30. Système selon l'une des revendications précédentes,
**caractérisé en ce que** le substrat (10) présente une finition de "HAL".

31. Système selon l'une des revendications précédentes,
**caractérisé en ce qu'**il est prévu au moins un autre composant électrique discret sur l'élément porteur (24) d'au moins une unité de commutation.

32. Système selon l'une des revendications précédentes,
**caractérisé en ce que** le substrat (10) est pourvu d'au moins un trou traversant (30) à travers lequel un talon respectif (28) d'un élément porteur (24) peut être enfiché.
